Europäisches Patentamt

European Patent Office

Office européen des brevets

(11) Veröffentlichungsnummer: **0 248 159 B1**

(12) **EUROPÄISCHE PATENTSCHRIFT**

(45) Veröffentlichungstag der Patentschrift:
08.08.90

(51) Int. Cl.⁵: **H02H 1/00**, G01R 33/02, G01R 15/02

(21) Anmeldenummer: 87104227.1

(22) Anmeldetag: 23.03.87

(54) Stromgrenzwertgeber für elektrische Schützlinge.

(30) Priorität: 05.06.86 DE 3618914

(43) Veröffentlichungstag der Anmeldung:
09.12.87 Patentblatt 87/50

(45) Bekanntmachung des Hinweises auf die Patenterteilung:
08.08.90 Patentblatt 90/32

(84) Benannte Vertragsstaaten:
AT CH DE IT LI NL

(56) Entgegenhaltungen:
EP-A- 0 156 016
FR-A- 2 389 986

IEEE TRANSACTIONS ON MAGNETICS, Band MAG-19, Nr. 5, September 1983, Seiten 2151-2153, IEEE, New York, US; K. MOHRI et al.: "Pulse-output type magnetic sensors using plastically helical amorphous ribbons"

(73) Patentinhaber: Siemens Aktiengesellschaft,
Wittelsbacherplatz 2, D-8000 München 2(DE)

(72) Erfinder: Güntner, Herwig, Dr. Dipl.-Ing.,
Wilhelm-Albrecht-Strasse 161, D-8540 Schwabach(DE)
Erfinder: Böke, Willi, Dipl.-Ing., Schweiggerstrasse 9,
D-8500 Nürnberg 30(DE)
Erfinder: Kugler, Robert, Dr. Dipl.-Ing., Kellerstrasse 40,
D-8508 Wendelstein(DE)

## Beschreibung

Die Erfindung betrifft einen Stromgrenzwertgeber für elektrische Schützlinge nach dem Oberbegriff des Anspruchs 1.

Die für einen Grenzwertgeber geeigneten Schaltvorrichtungen sind aus der EP-A 0 156 016 bekannt.

Die Schaltvorrichtung ist bei bekannten Stromwertgebern für elektrische Schützlinge mit ihrer Längsachse unveränderbar parallel zur homogenen Feldrichtung angeordnet.

Bei Ansteuerung des besagten Grenzwertgebers mit einem homogenen Wechselfeld in Längsrichtung der Schaltvorrichtung ergibt sich bei Erreichen einer bestimmten Auslösefeldstärke (z.B. 20A/cm) ein Spannungsimpuls von ausreichender Größe (ca. 2 V). Eine merkliche Überschreitung der Auslösefeldstärke (für ca. 300 A/cm) hat dabei keinen nachteiligen Einfluß auf den Zustand und das Verhalten, des Grenzwertgebers. Ein Überschreiten noch höherer Feldstärken des Wechselfeldes (z.B. 300 A/cm), die die Koerzitivfeldstärke des Dauermagnetdrahtes übersteigt, würde eine Entmagnetisierung des Dauermagnetendrahtes zur Folge haben, die eine Aufmagnetisierung mit einem entsprechend höheren Gegenfeld (mindestens 600 A/cm) erforderlich machen würde.

Im Arbeitsbereich eines solchen Stromwertgebers ist die Höhe des Spannungsimpulses nahezu unabhängig von der Frequenz des Wechselfeldes und von anderen Umgebungsbedingungen, insbesondere der Temperatur.

Bei Wechselfeldern werden somit bei der einen Feldrichtung Spannungsimpulse durch den Verbundkörper induziert und bei der anderen Feldrichtung der Verbundkörper wieder in seinen Ausgangszustand zurückgebracht, wobei kein Spannungsimpuls auftritt.

Somit kann der Grenzwertgeber bei der Überwachung von Wechselströmen ohne gesonderte Hilfsmittel eine entsprechende Folge von Spannungsimpulsen abgegeben, die wie ein Dauersignal wirkend eine nachgeordnete Auswerteschaltung speisen.

Bei der Überwachung von gleichstrombetriebenen Schützlingen ist ein gesonderter intervallweise zu aktivierender Rücksetzmagnet ausreichender Feldstärke erforderlich, der wie das Feld des zu überwachenden Stromes ein in Längsrichtung des Grenzwertgebers gerichtetes Gegenfeld aufbaut.

Für unterschiedliche Grenzwerte des überwachenden Stromes sind jeweils angepaßte und entsprechend bemessene Grenzwertgeber vorzusehen, die entsprechend fein justiert werden müssen, was einen erhöhten Aufwand erfordert, die Lagerhaltung erschwert und eine differenzierte Auswahl geeigneter Grenzwertgeber notwendig macht.

Der Erfindung liegt die Aufgabe zugrunde, mit einem oder nur wenigen Typen von Grenzwertgebern mit unterschiedlichen Grenzwerten bei unterschiedlichen Schützlingen auszukommen und eine einfache und genaue Abstimmung auf unterschiedliche Grenzwerte für jeden Schützling zu ermöglichen.

Die Lösung der gestellten Aufgabe gelingt durch die Maßnahmen im Kennzeichen des Anspruchs 1.

Der Stromgrenzwertgeber nach der Erfindung ist nachfolgend näher erläutert und in der Zeichnung schematisch veranschaulicht. Es zeigen:

Fig. 1 einen Stromgrenzwertgeber mit einer im homogenisierten Magnetfeld des Schützlings winkelverstellbar angeordneten Schaltvorrichtung in Verbindung mit einer Auswerteschaltung,

Fig. 2 eine Auswerteschaltung für Wechselfelder,

Fig. 3 eine schematische Auswerteschaltung für einen mit Gleichstrom betriebenen Schützling,

Fig. 4 den theoretischen sowie den gemessenen Zusammenhang zwischen dem Winkel $\alpha$ und dem jeweiligen Grenzstrom $I_{grenz}$.

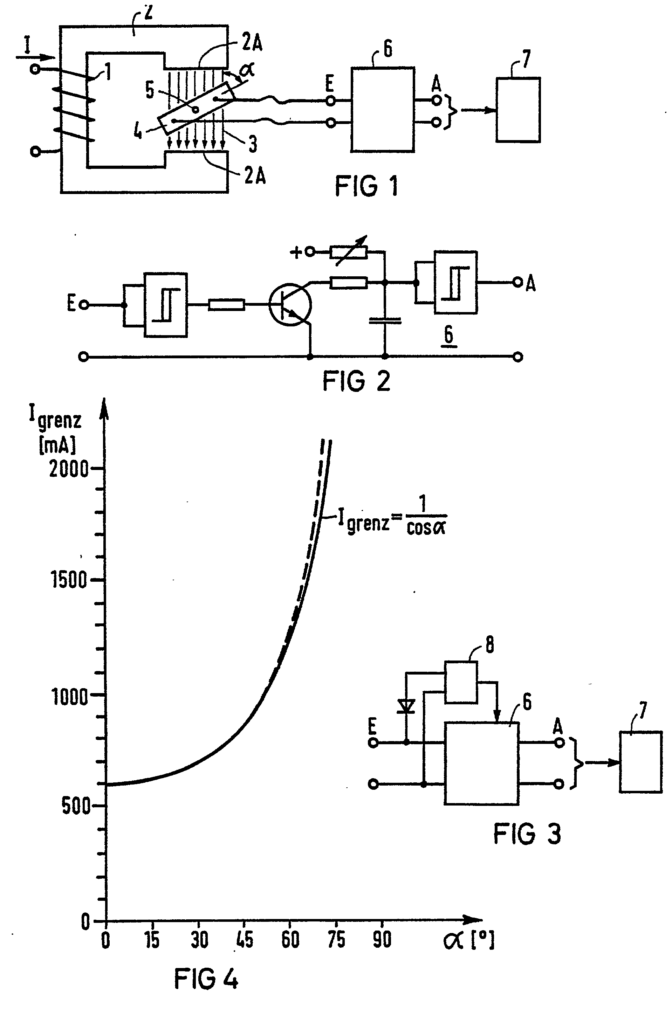

Gemäß Fig. 1 wird ein von Strom I des Schützlings durchflossene Wicklung 1 (oder in Durchsteckausführung bei Starkstrom-Schützlingen ein Leiter) zum ein geblechtes Eisenjoch 2 mit parallelen verbreiterten Polschuhen 2A zur Homogenisierung des Magnetfeldes 3 vorgesehen und zwischen den Polschuhen 2A eine stabförmige Schaltvorrichtung 4 der eingangs genannten Art mit einer quer zur Feldrichtung erstreckten Schwenkachse 5 angeordnet. Die Längsachse der Schaltvorrichtung ist um einen Winkel $\alpha$ zur Feldrichtung justierbar angeordnet, der zwischen 0 und 90 betragen kann, je nach dem zulässigen Grenzstrom $I_{grenz}$ des Schützlings und dem Ansprechwert der Feldstärke für den Grenzwertgeber.

Der bei Wechselfeldern ausreichender Feldstärke in der einen Feldrichtung jeweils auftretende Spannungsimpuls wird der Auswerteschaltung 6 zugeleitet, dort in eine kontinuierliche Spannung umgewandelt und diese einer Auslösevorrichtung 7 zum Abschalten des Schützlings zugeführt.

Bei einem gleichstromgespeisten Schützling muß die Auswerteschaltung 6 nach Fig. 3 mit einer elektronischen Zusatzvorrichtung 8 für die Erregung von Rücksetzimpulsen ergänzt sein, die mit einer gesonderten Stromquelle ausgerüstet intermittierend Rücksetzimpulse auf die Schaltvorrichtung 4 des Grenzwertgebers gibt bei gleichzeitiger Sperrung der Auswerteschaltung 6.

Zum Rücksetzen kann in nicht dargestellter Weise auch ein parallel zur Schaltvorrichtung 4 angeordneter zusätzlicher Permanentmagnet dienen.

In Fig. 4 ist der theoretische (durchgezogene Kurve) sowie der geringfügig abweichende gemessene (gestrichelte Kurve) Zusammenhang zwischen dem auslösenden Grenzstrom und dem Einstellwinkel $\alpha$ für ein Ausführungsbeispiel angegeben.

Die energiereichen Impulse der Schaltvorrichtung können z.B. direkt einen Optokoppler treiben, der mit der nachfolgenden Elektronik verbunden ist. Der Stromgrenzwertgeber nach der Erfindung ist infolge seines schnellen Ansprechens zur Auslösung von Schnellschaltern, insbesondere für elektrische Maschinen geeignet und zwar z.B. bei offenen oder gekapselten Niederspannungsleistungsschaltern.

Zur stromabhängigen zeitverzögerten Auslösung ($I^2.t$) können mehrere Schaltvorrichtungen der genannten Art so angeordnet werden, daß jeder ein maximaler Stromwert zugeordnet und elektronisch der $I^2$.t-Wert gebildet und diese einzelnen Werte addiert werden.

## Patentansprüche

1) Stromgrenzwertgeber für elektrische Schützlinge mit einer induktiven, frequenzunabhängigen Schaltvorrichtung (4), bestehend aus einem bewickelten draht- oder stabförmigen Verbundkörper aus mindestens zwei gegeneinander in Längsachse mechanisch verspannten Werkstoffen und mindestens einem in Längsrichtung des Verbundkörpers magnetisierten und mit diesem fest verbundenen Dauermagneten, der bei Ummagnetisierung des in seiner Längsachse eine magnetische Vorzugsrichtung aufweisenden Verbundkörpers durch die Einwirkung eines äußeren Magnetfeldes bei einer die Schaltschwelle in bestimmter Richtung überschreitenden Feldstärke in der den Verbundkörper umgebenden Wicklung einen frequenzunabhängigen Spannungsimpuls zur weiteren Auswertung hervorruft, **dadurch gekennzeichnet**, daß die Schaltvorrichtung (4) zur Überwachung unterschiedlicher stromdurchflossener Schützlinge in einem vom Strom des jeweiligen Schützlings hervorgerufenen, homogenisierten Magnetfeld zu dessen Feldrichtung in ihrer Längsachse unter einem Winkel α angeordnet und über flexible Leiter mit einer außerhalb des Magnetfeldes angeordneten Auswerteschaltung (6) verbunden ist, wobei der Winkel α zwischen der Längsachse der Schaltvorrichtung (4) (Verbundkörper) und der Feldrichtung zumindest angenähert entsprechend der Beziehung zwischen dem Grenzstrom des Schützlings

$$I_{grenz} = \frac{1}{\cos\alpha}$$

gewählt ist.

2) Schaltvorrichtung nach Anspruch 1, **dadurch gekennzeichnet**, daß sie um eine zu ihrer Längsachse mittig quer zur Feldrichtung angeordnete Schwenkachse (5) im Magnetfeld verstellbar ist.

3) Schaltvorrichtung nach Anspruch 1 oder 2, **dadurch gekennzeichnet**, daß sie zwischen den Polflächen (2A) eines geblechten, vom Strom des Schützlings induzierten Eisenjoches (2) angeordnet ist.

4) Schaltvorrichtung nach einem der vorhergehenden Ansprüche für gleichstromgespeiste Schützlinge, **dadurch gekennzeichnet**, daß eine gesonderte Stromversorgung (8) zur intermittierenden Aussendung von Rücksetzsignalen auf die Schaltvorrichtung (4) und zur gleichzeitigen intermittierenden Sperrung der Auswerteschaltung (6) vorgesehen ist.

5) Schaltvorrichtung nach einem der vorhergehenden Ansprüche, **dadurch gekennzeichnet**, daß zum Rücksetzen der Schaltvorrichtung (4) dieser ein zusätzlicher Permanentmagnet parallelgeschaltet ist.

## Revendications

1. Transmetteur de valeur limite de courant pour des dispositifs électriques protégés comportant un dispositif inductif de commutation (4) indépendant de la fréquence, constitué par un corps composite enroulé en forme de fil ou de barre et formé par au moins deux matériaux serrés mécaniquement l'un contre l'autre dans la direction de l'axe longitudinal, et au moins un aimant permanent, aimanté dans la direction longitudinale du corps composite et relié rigidement à ce dernier et qui, lors d'une désaimantation du corps composite possédant une direction magnétique préférentielle s'étendant dans la direction de son axe longitudinal, délivre, sous l'action d'un champ magnétique extérieur, dans le cas où l'intensité de champ dans l'enroulement entourant le corps composite dépasse le seuil de commutation dans une direction déterminée, une impulsion de tension indépendante de la fréquence et utilisée pour une évaluation ultérieure, caractérisé par le fait que, pour le contrôle de différents dispositifs protégés parcourus par un courant et placés dans un champ magnétique homogénéisé produit par le courant du dispositif protégé respectif, le dispositif de commutation (4) est disposé de telle sorte que son axe longitudinal fait un angle α par rapport à la direction du champ magnétique et est relié par l'intermédiaire de conducteurs flexibles à un circuit d'évaluation (6) disposé à l'extérieur du champ magnétique, l'angle a entre l'axe longitudinal du dispositif de commutation (4) (corps composite) et la direction du champ étant choisi de manière à correspondre au moins approximativement à la relation fournissant le courant limite du dispositif protégé

$$I_{limite} = \frac{1}{\cos\alpha}.$$

2. Dispositif de commutation suivant la revendication 1, caractérisé par le fait qu'il est déplaçable dans le champ magnétique autour d'un axe de pivotement (5) disposé d'une manière centrée par rapport à son axe longitudinal et transversalement par rapport à la direction du champ.

3. Dispositif de commutation suivant la revendication 1 ou 2 , caractérisé par le fait qu'il est disposé entre les surfaces polaires (2A) d'une culasse en fer feuilleté (2), dans laquelle une induction est produite par le courant du dispositif protégé.

4. Dispositif de commutation suivant l'une des revendications précédentes pour des dispositifs protégés alimentés par un courant continu, caractérisé par le fait qu'il est prévu une alimentation séparée en courant (8) pour l'envoi intermittent de signaux de remise à l'état initial au dispositif de commutation (4) et pour bloquer simultanément de façon intermittente le circuit d'évaluation (6).

5. Dispositif de commutation suivant l'une des revendications précédentes, caractérisé par le fait que pour la mise à l'état initial du dispositif de commutation (4), un aimant permanent supplémentaire est branché en parallèle avec ce dispositif.

## Claims

1. Current limit value detector for protected electrical devices, having an inductive, non-frequency-dependent switching device (4), consisting of a wound wire or rod-type composite body made from at least two materials mechanically braced against each other in the longitudinal axis, and at least one permanent magnet which is magnetised in the longitudinal direction of the composite body and firmly connected thereto, which permanent magnet generates a non-frequency-dependent voltage pulse in the winding surrounding the composite body, for the further evaluation, when the composite body, which has a preferred direction of magnetisation in its longitudinal axis, is demagnetised by the effect of an outside magnetic field, with a field strength exceeding the switching threshold in a specified direction, characterised in that the switching device (4) for monitoring different protected devices having current flowing through them, is arranged in a uniform magnetic field generated by the current of the respective protected device, with its longitudinal axis at an angle α to the field direction of the said uniform magnetic field, and is connected by way of flexible conductors to an evaluation circuit (6) arranged outside the magnetic field, the angle α between the longitudinal axis of the switching device (4) (composite body) and the field direction being selected so that it corresponds at least approximately to the relationship between the limit current of the protected device limit = 1/cosα.

2. Switching device according to claim 1, characterised in that it can be adjusted within the magnetic field around a pivoting axis (5) arranged in the middle of its longitudinal axis, transverse to the field direction.

3. Switching device according claim 1 or 2, characterised in that it is arranged between the pole faces (2A) of a laminated iron yoke (2) induced by the current of the protected device.

4. Switching device according to one of the preceding claims for protected devices fed by direct current, characterised in that a separate current supply (8) is provided for the intermittent transmission of resetting signals to the switching device (4) and for the simultaneous intermittent blocking of the evaluation circuit (6).

5. Switching device according to one of the preceding claims, characterised in that, for resetting the switching device (4), an additional permanent magnet is connected in parallel to the said switching device (4).

FIG 1

FIG 2

$$I_{grenz} = \frac{1}{\cos\alpha}$$

FIG 3

FIG 4